(19) Europäisches Patentamt
European Patent Office
Office européen des brevets

(11) **EP 3 149 784 B1**

(12) **EUROPÄISCHE PATENTSCHRIFT**

(45) Veröffentlichungstag und Bekanntmachung des Hinweises auf die Patenterteilung:
**19.08.2020 Patentblatt 2020/34**

(21) Anmeldenummer: **15724722.2**

(22) Anmeldetag: **31.05.2015**

(51) Int Cl.:
***H01L 33/58*** *(2010.01)*

(86) Internationale Anmeldenummer:
**PCT/EP2015/062051**

(87) Internationale Veröffentlichungsnummer:
**WO 2015/185466 (10.12.2015 Gazette 2015/49)**

(54) **BELEUCHTUNGSVORRICHTUNG**

LIGHTING DEVICE

DISPOSITIF D'ÉCLAIRAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.06.2014 EP 14170820**

(43) Veröffentlichungstag der Anmeldung:
**05.04.2017 Patentblatt 2017/14**

(73) Patentinhaber: **Swareflex GmbH**
**6134 Vomp (AT)**

(72) Erfinder: **GIANORDOLI, Stefan**
**A-2500 Baden (AT)**

(74) Vertreter: **dompatent von Kreisler Selting Werner - Partnerschaft von Patent- und Rechtsanwälten mbB**
**Deichmannhaus am Dom**
**Bahnhofsvorplatz 1**
**50667 Köln (DE)**

(56) Entgegenhaltungen:
**EP-A2- 1 191 608        WO-A2-2009/132837**
**US-A1- 2011 062 469     US-A1- 2011 062 469**
**US-A1- 2011 062 471     US-A1- 2012 153 306**

**Beschreibung**

## GEBIET DER ERFINDUNG

Die Erfindung befindet sich auf dem Gebiet der Elektrotechnik und hat eine Beleuchtungsvorrichtung, speziell eine so genannte Flip-Chip LED ("FC LED"), zum Gegenstand, die aus einem Verbund aus einem Leuchtelement und einem Träger ("LED Chip") sowie einem Primäroptikelement besteht sowie deren Verwendung zur Beleuchtung von Objekten.

## STAND DER TECHNIK

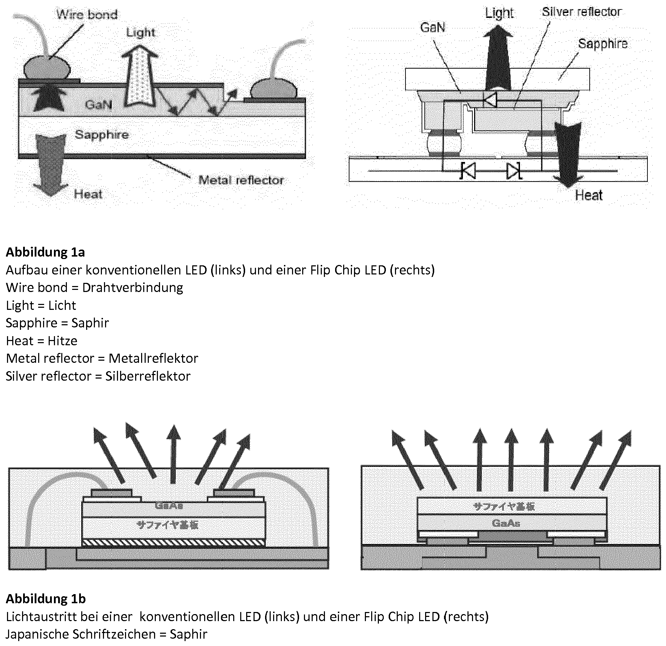

Unter Flip-Chip LED wird eine Technologie verstanden, bei der das Beleuchtungselement - üblicherweise eine LED -auf dem Kopf stehend montiert wird, wie dies in **Abbildung 1a** dargestellt ist. Erste Schutzrechte hierzu gehen auf Matsushita zurück (z.B. JP 57 092881 A1**)** und datieren aus den frühen 80er Jahren des vergangenen Jahrhunderts. Heute gibt es mehr als 1000 Patentveröffentlichungen zu diesem Thema.

In diesem Zusammenhang sei auf die US 2011 062469 A1 (PHILIPS) hingewiesen. Gegenstand dieser Schrift ist eine lichtemittierende Einheit, bestehend aus einer LED, einer Linse, einem Fensterelement, einer Verbindung an der Grenzfläche zwischen Linse und Fensterelement, wobei das Fensterelement an die Linse gebunden ist. EP1191608 A2 offenbart eine weitere Beleuchtungsvorrichtung, wobei das Primäroptikelement durch Ansprengen am Träger befestigt ist.

Die US 2012 153306 A1 (YAO) offenbart einen Leuchtdioden-Chip (LED-Chip) umfassend: eine Flip-Chip-LED, und eine Linse, die auf der obersten Oberfläche der Flip-Chip-LED angebracht ist, wobei diese Linse ein nichtpolymeres Material enthält und im Wesentlichen keine Polymermaterialien mit dem LED-Chip in Kontakt kommen.

**Aus der** US 2011 062471 A1 (BIERHUIZEN). Diese Anmeldung betrifft ein LED Modul mit Linse, das einen modularen Aufbau aufweist, wobei das LED-Modul mit dem Träger verklebt wird.

**Die** WO 2009 132837 A2 (SCHOTT) beansprucht einen Konverterbaustein für die von einem optoelektronischen Funktionselement emittierte und/oder zu empfangende Strahlung, vorzugsweise von einer LED, zum Aufsetzen auf ein opto-elektronische Funktionselement, welches zumindest einen Konverter zur Konversion der emittierten und/oder zu empfangenden Strahlung, zumindest ein optisches Bauelement, wobei der Konverter und das optische Bauelement zumindest abschnittsweise aneinander liegen und verbunden sind.

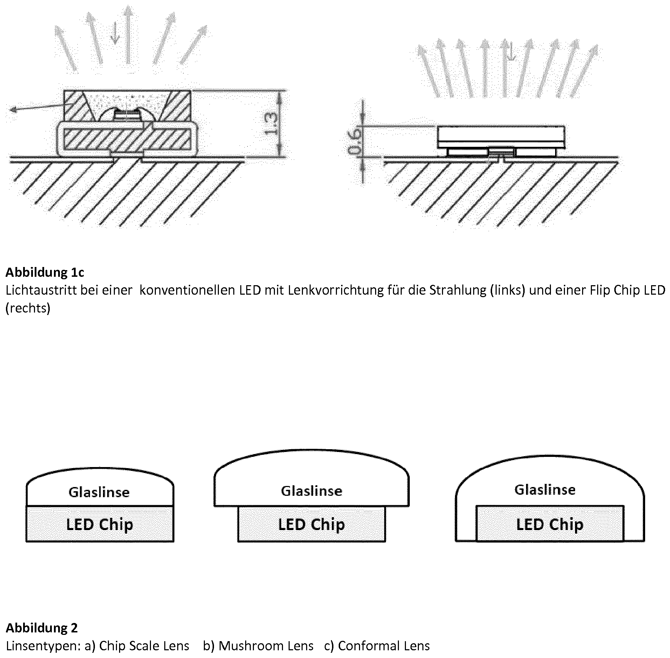

FC LED weisen gegenüber den konventionellen Produkten eine Reihe von wichtigen Vorteilen auf, insbesondere gewährleisten sie eine schnellere Wärmeableitung, was die Lebensdauer signifikant erhöht. FC LED benötigen auch keine Vorrichtungen, um das Licht in eine bestimmte Richtung zu lenken und gewährleisten auch bei Reflexion eine hohe Bildhelligkeit, wie dies schematisch in den **Abbildungen 1b und 1c** wiedergegeben ist.

Ein weiterer wichtiger Gesichtspunkt ist, dass sich FC LED leichter und schneller herstellen lassen, weil ausgehend vom Epi-Wafer nur noch ein "die bonding" sowie eine Modulierung erforderlich sind, um das Bauteil fertigzustellen. Damit werden also insbesondere das "wire bonding" und das Verkapseln des Leuchtstoffs eingespart.

Die Chips werden meist von transparenten linsenförmigen Hohlkörpern umhüllt, wobei als Material in aller Regel Kunststoffe, vor allem Polydimethylsiloxane eingesetzt werden. Diese haben sich speziell bei den bekannten und bewährten nitridbasierten Verbindungshalbleiterchips durchgesetzt, da sie die austretende Strahlung nicht absorbieren und daher keine oder nur sehr geringe Verschleißerscheinungen zeigen.

Silikone weisen jedoch ausgesprochen niedrige Brechungsindices auf, die typisch bei 1,40 bis 1,41 liegen. Dies bedeutet, dass zwischen dem Chip und der Umhüllung in der Regel ein erheblicher Unterschied im Brechungsindex besteht, der dazu führt, dass die Strahlungsauskopplung aus dem Chip stark verringert wird.

In der Vergangenheit hat man versucht, dieses Problem dadurch zu lösen, dass man die Polydimethylsiloxane chemisch modifiziert, beispielsweise durch den Einbau aromatischer Gruppen. Tatsächlich sind diese Ansätze eher kontraproduktiv, denn die Modifizierung der Siloxane führt im Ergebnis zu einer Zunahme bei der Absorption des aus dem Chip austretenden Lichtes in den Silikonkörper, so dass die austretende Strahlung nicht verstärkt, sondern verringert wird, das Silikongehäuse seine Transparenz zunehmen einbüßt und dadurch sich die Absorptionsverluste abermals erhöhen.

Ein weiterer Nachteil im Zusammenhang mit der Verwendung von Silikonen als Hüllkörper für FC LED ist, dass der Brechungsindex bei steigender Temperatur kleiner wird, dass sie eine hohe Permeabilität für Gase und Wasser aufweisen und nur eine geringe Härte besitzen.

Die Aufgabe der vorliegenden Erfindung hat somit darin bestanden, Beleuchtungsvorrichtungen vom Typ der Flip-Chip LED zur Verfügung zu stellen, die die geschilderten Nachteile des Stands der Technik überwinden. Insbesondere sollten die Bauteile mit Hüllkörpern ausgestattet sein, die einen ähnlichen Brechungsindex wie der Verbund aus Träger und Leuchtelement aufweisen, resistent gegen Temperatur- und Umwelteinflüsse sein, keine Permeabilität für Gase und Wasser aufweisen und eine höhe Härte als Polysiloxane besitzen.

## BESCHREIBUNG DER ERFINDUNG

Gegenstand der Erfindung ist eine Beleuchtungsvorrichtung umfassend

(a) ein Leuchtelement,

(b) einen Träger sowie

(c) ein Primäroptikelement

die sich dadurch auszeichnet, dass

(i) das Leuchtelement (a) auf dem Träger (b) befindlich ist und

(ii) das Primäroptikelement (c) dergestalt auf dem Verbund aus Leuchtelement (a) und Träger (b) angeordnet ist, dass es die aus dem Leuchtelement austretende Strahlung aufnimmt, lenkt und in der gewünschten Lichtverteilung abstrahlt, wobei

(iii) das Primäroptikelement (c) aus hochbrechendem Glas gefertigt und

(iv) durch Ansprengen am Träger befestigt ist, wobei das Glas Oxide von vier-, zwei- und einwertigen Metallen aufweist.

Überraschenderweise wurde gefunden, dass Primäroptikelemente, die aus einem hochbrechenden Glas gefertigt und direkt durch Ansprengen (auch als "direct bonding" oder "physical bonding" bezeichnet) am LED Chip befestigt sind, die Aufgabe voll umfänglich lösen. Zwischen dem Primäroptikelement und dem LED Chip befindet sich also keine gesonderte Verbindungsschicht, wie beispielsweise ein Klebstoff, da dies zu ähnlichen Problemen wie eingangs geschildert führen würde.

## LEUCHTELEMENTE

Auch wenn im Rahmen der vorliegenden Erfindung häufig von Flip Chip LED die Rede ist, weil dies bislang der *Terminus Technicus* für die vorliegende Technologie darstellt, so ist die Erfindung doch nicht auf die Ausführungsform des Leuchtelementes als LED beschränkt. Tatsächlich kann es sich dabei ebenso um eine OLED, eine LET oder eine OLET handeln.

## LED

LED, auch als Leuchtdioden bezeichnet, stellen lichtemittierende HalbleiterBauelemente dar, deren elektrische Eigenschaften denen einer Diode entspreche. Fließt durch die Diode elektrischer Strom in Durchlassrichtung, so strahlt sie Licht, IR-Strahlung und UV-Strahlung mit einer vom Halbleitermaterial und dessen Dotierung anhängigen Wellenlänge ab.

Der Halbleiterkristall vieler Leuchtdioden ist auf den Boden einer kegelförmigen Vertiefung in einem Metallhalter gelötet. Die Innenseiten der Vertiefung wirken als Reflektor für das aus den Seiten des Kristalls austretende Licht. Die Lötstelle bildet einen der beiden elektrischen Anschlüsse des Kristalls. Gleichzeitig nimmt sie die Abwärme auf, die entsteht, weil der Halbleiterkristall nur einen Teil der elektrischen Leistung in Licht umsetzt. Der Halter mit dem Reflektor ist bei bedrahteten Leuchtdioden als Draht mit rechteckigem Querschnitt ausgeführt, der als elektrischer Anschluss dient. Anders als sonst bei Elektronikbauteilen üblich besteht der Anschlussdraht nicht aus verzinntem Kupfer, sondern aus verzinntem Stahl. Die Wärmeleitfähigkeit von Stahl ist vergleichsweise gering. Dadurch wird der Halbleiterkristall beim Einlöten des Bauteils in eine Leiterplatte nicht durch Überhitzung zerstört. Die Oberseite des Kristalls ist nur durch einen dünnen Bonddraht elektrisch mit dem zweiten Stahlanschlussdraht verbunden, damit der Anschluss nur sehr wenig der lichtemittierenden Oberfläche verdeckt.

Hochleistungs-Leuchtdioden (H-LED) werden mit höheren Strömen als 20 Milliampere betrieben. Es entstehen besondere Anforderungen an die Wärmeableitung, die sich in speziellen Bauformen ausdrücken. Die Wärme kann über die Stromzuleitungen, die Reflektorwanne oder in den Leuchtdiodenkörper eingearbeitete Wärmeleiter abgeführt werden.

Weitere geeignete LED-Ausführungen, die im Sinne der vorliegenden Erfindung als Lichtquellen eingesetzt werden können, umfassen das direkte Drahtbonden des Leuchtdioden-Chips auf der Platine (*chip on board*) und der spätere Verguß mit Silikonmassen.

Die als Lichtquellen eingesetzten LED können auch mehrfarbig sein. Mehrfarbige Leuchtdioden bestehen aus mehreren (zwei oder drei) Dioden in einem Gehäuse. Meist haben sie eine gemeinsame Anode oder Kathode und einen Anschluss für jede Farbe. Bei einer Ausführung mit zwei Anschlüssen sind zwei Leuchtdioden-Chips antiparallel geschaltet. Je nach Polarität leuchtet die eine oder andere Diode. Eine quasi stufenlose Farbveränderung kann man über ein variables Pulsbreitenverhältnis eines geeigneten Wechselstroms realisieren.

Der prinzipielle Aufbau der Leuchtdioden der Erfindung entspricht dem einer pn-Halbleiterdiode; Leuchtdioden besitzen daher die gleichen Grundeigenschaften wie diese. Ein großer Unterschied besteht in dem verwendeten Halbleitermaterial. Während nichtleuchtende Dioden aus Silizium, seltener aus Germanium oder Selen hergestellt werden, ist das Ausgangsmaterial für Leuchtdioden ein direkter Halbleiter, meist eine Galliumverbindung als III-V-Verbindungshalbleiter.

Wird an eine Halbleiterdiode eine Spannung in Durchlassrichtung angelegt, wandern Elektronen von der n-dotierten Seite zum p-n-Übergang. Nach Übergang zur p-dotierten Seite geht das Elektron dann in das energetisch günstigere Valenzband über. Dieser Übergang wird Rekombination genannt, denn er kann auch als Zusammentreffen von einem Elektron im Leitungsband mit einem Defektelektron (Loch) interpretiert werden. Die bei der Rekombination frei werdende Energie kann in einem direkten Halbleiter als Licht (Photon) abgegeben werden.

Neben der direkten strahlenden Rekombination ist auch die Beteiligung von Exzitonen und Phononen möglich, was zu etwas weniger energiereicher Strahlung und zu einer Verschiebung des emittierten Lichtes in den längerwelligen Bereich führt. Dieser Mechanismus spielt insbesondere bei exzitonischer Emission in grünen Galliumphosphid-Leuchtdioden eine Rolle.

Die Bandstruktur des Halbleiters bestimmt unter anderem das Verhalten der Energieübertragung beim Übergang eines Elektrons vom Leitungs- ins Valenzband und entgegengesetzt. Bei den LED, die im Rahmen der vorliegenden Erfindung geeignet sind, kommen ausschließlich direkte Halbleiter in Betracht. Diese, zeichnen sich durch einen "direkten Bandübergang" aus, was bedeutet, dass die Elektronen am unteren Rand des Leitungsbands (Leitungsbandminimum) und am oberen Ende des Valenzbands (Valenzbandmaximum) denselben Impuls haben. Damit ist ein direkter Übergang des Elektrons unter Aussendung eines Photons (Licht) möglich, ohne dass ein Phonon zur Impulserhaltung beteiligt sein muss. Die Quantenausbeute des direkten Halbleiters GaAs liegt bei ca. 0.5, beim indirekten Halbleiter Si nur bei etwa $1 \cdot 10^{-5}$.

Die Energie des emittierten Photons ist gleich der Energie der Bandlücke, also dem energetischen Abstand zwischen Leitungs- und Valenzband,

$$\lambda(W_{\mathrm{D}}) = \frac{h \cdot c}{W_{\mathrm{D}}}$$

mit $W_{\mathrm{D}} = E'' - E'$
wobei $\lambda_{(WD)}$ die Wellenlänge des emittierten Lichtes, h das Planck'sche Wirkungsquantum, c die Lichtgeschwindigkeit und $W_{\mathrm{D}}$ die Arbeit darstellt.

Die Größe der Bandlücke, also der Energielücke $E''$-$E'$ bestimmt die Energie, das heißt, die Frequenz, Wellenlänge bzw. Farbe, des ausgesandten Lichtes. Sie lässt sich über die chemische Zusammensetzung des Halbleiters steuern. So verändert der Austausch von Atomen im Kristallgitter den kristallinen/molekularen Aufbau des Materials, u.a. seine Gitterparameter oder sogar seine Gitterstruktur. Beispielsweise hat der Halbleiter Galliumarsenid einen direkten Bandabstand von 1,4 eV, entsprechend einer Wellenlänge von 885 nm, d.h. im Nah-IR-Bereich. Die Zugabe von Phosphor vergrößert den Bandabstand, was das ausgesandte Licht energiereicher macht, wobei die Wellenlänge abnimmt und die Farbe von Infrarot zu Rot und Gelb übergeht. Durch die Zunahme von Phosphor im Kristall verformt sich jedoch auch das Leitungsband. Wenn Phosphor 50 Prozent der Arsen-Atome ersetzt, liegt der Bandabstand zwar bei fast zwei Elektronenvolt, was einer Strahlung von 650 nm (Rot) entspricht, dafür hat sich die Bandstruktur so verschoben, dass keine direkten Strahlungsübergänge mehr beobachtet werden, wie im Beispiel rechts gezeigt. Die Energie der Bandlücke spiegelt sich auch in der Höhe der Durchlassspannung der Diode wider. Bei langwelligem Licht liegt sie bei ca. 1.5 V, bei blauem Licht bei 3 V.

Durch die gezielte Auswahl der Halbleitermaterialien und der Dotierung können die Eigenschaften des erzeugten Lichtes variiert werden. Vor allem der Spektralbereich und die Effizienz lassen sich so beeinflussen:

- Aluminiumgalliumarsenid (AlGaAs) - rot (665 nm) und infrarot bis 1000 nm Wellenlänge

- Galliumarsenidphosphid (GaAsP) und Aluminiumindiumgalliumphosphid (AlInGaP)-rot, orange und gelb

- Galliumphosphid (GaP)-grün

- Siliziumkarbid (SiC) - erste kommerzielle blaue LED;

- Zinkselenid (ZnSe) - blauer Emitter;

- Indiumgalliumnitrid (InGaN)/Galliumnitrid (GaN) - Ultraviolett, Violett, blau und grün;

- Weiße LEDs, die im Sinne der vorliegenden Erfindung bevorzugt werden, sind meistens blaue LEDs mit einer davor befindlichen Lumineszenzschicht, die als Wellenlängen-Konverter wirkt.

Die erfindungsgemäße Beleuchtungsvorrichtung eignet sich besonders bevorzugt für nitridbasierte LED-Chips, kann jedoch ebenso bei anderen Chip-Typen, wie beispielsweise phosphidbasierte LED-Chips, welche beispielsweise GaP, AlP, InP, InGaP, AlGaP und/oder InGaAlP-Halbleiermaterial aufweisen, Einsatz finden. Solche LED-Chips sind unter anderem aus "Lighting your path to the future", Philips Lumileds Lighting Company, IMAPS November 2007 (abzurufen unter www.**imaps**.org/gbc/**IMAPS**07/GBC1_**PhilipsLumileds**.pdf) bekannt und werden von daher an dieser Stelle nicht mehr näher erläutert.

## OLED

Eine besonders bevorzugte Lichtquelle im Sinne der Erfindung sind OLED. Dabei handelt es sich um organische Leuchtdioden, genauer gesagt um leuchtende Dünnschichtbauelemente aus organischen halbleitenden Materialien, das sich von den anorganischen Leuchtdioden (LED) dadurch unterscheiden, dass die elektrische Stromdichte und Leuchtdichte geringer und keine einkristallinen Materialien erforderlich sind. Im Vergleich zu herkömmlichen (anorganischen) Leuchtdioden lassen sich organische Leuchtdioden daher in Dünnschichttechnik kostengünstiger herstellen. OLEDs sind aus mehreren organischen Schichten aufgebaut. Dabei wird meist auf die Anode, bestehend aus Indium-Zinn-Oxid (ITO), die sich auf einer Glasscheibe befindet, eine Lochleitungsschicht (*hole transport layer,* HTL) aufgebracht. Zwischen ITO und HTL wird - abhängig von der Herstellungsmethode - oft noch eine Schicht aus PEDOT/PSS aufgebracht, die zur Absenkung der Injektionsbarriere für Löcher dient und die Eindiffusion von Indium in den Übergang verhindert. Auf die HTL wird eine Schicht aufgebracht, die entweder den Farbstoff enthält (ca. 5-10 %) oder - eher selten -vollständig aus dem Farbstoff besteht, z. B. Aluminium-tris(8-hydroxychinolin), Alq3. Diese Schicht bezeichnet man als Emitterschicht (*emitter layer,* EL). Auf diese wird optional noch eine Elektronenleitungsschicht (*electron transport layer,* ETL) aufgebracht. Zum Abschluss wird eine Kathode, bestehend aus einem Metall oder einer Legierung mit geringer Elektronenaustrittsarbeit wie zum Beispiel Calcium, Aluminium, Barium, Ruthenium, Magnesium-Silber-Legierung, im Hochvakuum aufgedampft. Als Schutzschicht und zur Verringerung der Injektionsbarriere für Elektronen wird zwischen Kathode und E(T)L meistens eine sehr dünne Schicht aus Lithiumfluorid, Cäsiumfluorid oder Silber aufgedampft.

Die Elektronen werden nun von der Kathode injiziert, während die Anode die "Löcher", d.h. die positive Ladung bereitstellt. Loch und Elektron driften aufeinander zu und treffen sich im Idealfall in der EL, weshalb diese Schicht auch Rekombinationsschicht genannt wird. Elektronen und Löcher bilden einen gebundenen Zustand, den man als Exziton bezeichnet. Abhängig vom Mechanismus stellt das Exziton bereits den angeregten Zustand des Farbstoffmoleküls dar, oder der Zerfall des Exzitons stellt die Energie zur Anregung des Farbstoffmoleküls zur Verfügung. Dieser Farbstoff hat verschiedene Anregungszustände. Der angeregte Zustand kann in den Grundzustand übergehen und dabei ein Photon (Lichtteilchen) aussenden. Die Farbe des ausgesendeten Lichts hängt vom Energieabstand zwischen angeregtem und Grundzustand ab und kann durch Variation der Farbstoffmoleküle gezielt verändert werden. Ein Problem stellen nichtstrahlende Triplett-Zustände dar. Diese können durch Zugabe von sogenannten "Exzitoren" wieder gelöst werden.

Anstelle der Licht emittierenden Dioden können auch entsprechende Transistoren verwendet werden, die als LET oder OLET bezeichnet werden.

## TRÄGER

Wie eingangs erläutert bilden das Leuchtelement (b) und der Träger (c) den sogenannt Chip bzw. LED Chip.

Die dem Primäroptikelement zugewandte Seite des Chips kann dabei, je nach zugrundeliegender Technologie und expliziter Ausgestaltung des LED-Chips, beispielsweise Saphir, SiC, GaN, InGaN, AlGaN, AlGaInN, Glas, Phosphor in Glas oder Phosphor in Keramik (man vergleiche diesbezüglich die in oben genannter Veröffentlichung, Seite 12, beschriebene TFFC LED mit Lumiramic™) aufweisen. Glas, Phosphor in Glas oder Phosphor in Keramik werden in diesem Zusammenhang als Bestandteil des LED-Chips gesehen.

## PRIMÄROPTIKELEMENTE

Bei dem Primäroptikelement handelt es sich vorzugsweise um eine Linse, speziell um eine Linse aus einem hochbrechenden Glas. Vorzugsweise besitzt das Element bzw. die Linse eine dem LED Chip zugewandte planare Ebene, während deren vom LED Chip abgewandte Seite eine die gewünschte Lichtverteilung erzeugende Kontur aufweist.

Das Primäroptikelement kann so ausgeführt sein, dass es im Wesentlichen nur die Oberfläche des LED Chips bedeckt ("chip scale lens" - **Abbildung 2a).** Diese Ausführung wird besonders dann gewählt, wenn das im LED-Chip erzeugte Licht im Wesentlichen durch die dem Primäroptikelement zugewandte Oberfläche abgestrahlt wird.

Das Primäroptikelement kann aber auch über den LED-Chip hinausragen ("mushroom lens" - **Abbildung 2b)** und an den über die Chipfläche hinausragenden Flächen Verankerungspunkte bilden.

In einer weiteren Ausführungsform kann das Primäroptikelement aber auch mit einer Aussparung in der dem LED-Chip zugewandten Seite ausgeführt werden, die den Chip aufnimmt. Durch diesen Weg der Einbettung des Chips in das Glas kann auch das an den Seitenflächen des Chips austretende Licht in den Glaskörper übertreten ("conformal lens" - **Abbildung 2c).**

## GLASZUSAMMENSETZUNG

Ein weiteres kritisches Merkmal der Erfindung betrifft die Zusammensetzung der Gläser, aus denen die Primäroptikelemente bzw. die Linsen bestehen. Dabei ist als erstes anzumerken, dass schon der Umstand, dass die Linsen überhaupt aus Glas und nicht wie inzwischen üblich aus Polysiloxan bestehen, für den technischen Erfolg der Erfindung mitverantwortlich ist. Nur mit Glaslinsen lassen sich so präzise Lichteinstrahlungen erreichen und nur mit Glaslinsen können auch die Anforderungen an die Beständigkeit erfüllt werden.

Es ist weiterhin erforderlich, dass die Gläser Oxide von vier-, zwei- und einwertigen Metallen aufweisen. Die vierwertigen Metalloxide sind dabei ausgewählt aus der Gruppe, die gebildet wird von Siliziumdioxid, Titandioxid und Zirkondioxid, sowie deren Mischungen.

Die zweiwertigen Metalloxide sind ausgewählt aus der Gruppe, die gebildet wird von Calciumoxid, Magnesiumoxid und Zinkoxid sowie deren Mischungen.

Die einwertigen Metalloxide sind ausgewählt aus der Gruppe, die gebildet wird von Natriumoxid, Kaliumoxid und Lithiumoxid sowie deren Mischungen.

Vorzugsweise sind die einzelnen Metalloxide in jeder der drei Gruppen in etwa gleichen Mengen enthalten. Ausnahme bildet die Gruppe der vierwertigen Metalloxide, in denen naturgemäß die Menge an Siliziumdioxid deutlich überragt. Es ist des Weiteren vorteilhaft, wenn die Gläser alle neuen ausdrücklich genannten Oxide enthalten.

Konkrete Beispiele für geeignete Glaszusammensetzungen sind in **Tabelle 1** offenbart. Besonders bevorzugte Zusammensetzungen umfassen:

(a1) etwa 58 bis etwa 63 Gew.-% vierwertige Metalloxide,

(a2) etwa 14 bis etwa 22 Gew.-% zweiwertige Metalloxide,

(a3) etwa 14 bis etwa 20 Gew.-% einwertige Metalloxide,

mit der Maßgabe, dass sich die Mengenangaben zu 100 Gew.-% addieren.

Eine weiter kritische Größe stellt der Brechungsindex $n_D$ dar, der vorzugsweise einen Wert von mindestens 1,5, vorzugsweise von mindestens 1,55, besonders bevorzugt von mindestens 1,6 und insbesondere bevorzugt von etwa 1,7 bis etwa 1,9 aufweist.

Die Gläser zeichnen sich zudem dadurch aus, dass bei Ausdehnungskoeffizienten von weniger als $10*10^{-6}$ $K^{-1}$, vorzugsweise $6 * 10^{-6}$ $K^{-1}$ und Schichtdicken von 10 mm im Spektralbereich von 400-800 nm Transmissionen von mindestens 85 %, bevorzugt mindestens 90 % erreicht werden.

Vorteilhafterweise besitzen die Gläser eine Dichte von etwa 2,65 bis etwa 2,75 $g/cm^3$ und insbesondere von etwa 2,68 bis 2,73 $g/cm^3$.

Ebenfalls bevorzugt sind Gläser, die eine definierte Vickershärte von etwa 600 bis etwa 650 HV 0,1/20 aufweisen.

## ANSPRENGEN

Beim Ansprengen (auch Anschieben) werden zwei glatte, ebene Oberflächen nur durch deren molekulare Anziehungskräfte verbunden. Dazu müssen diese frei von Staub, Fett oder sonstigen Verschmutzungen sein. Kritisch für die vorliegende Erfindung ist daher, dass die zu verbindenden Oberflächen der Einheit aus dem Primäroptikelement (a) einerseits und dem Verbund aus Leuchtelement (b) und Träger (c) andererseits eine ausreichende Rauheit ($R_a$) und Ebenheit (PV) aufweisen.

Die Oberflächen sollten insbesondere eine Rauheit ($R_a$) von weniger als 10 nm und insbesondere weniger als 5 nm sowie vorzugsweise eine Ebenheit (PV) von weniger als 100 nm und insbesondere von weniger als 50 nm aufweisen.

Derartige Oberflächenqualitäten können beispielsweise mittels Schleifen und Polieren, mittels chemisch-mechanischem Polierens (CMP) und/oder mittels Säurepolierens erzielt werden. Speziell bevorzugt ist die Kombination aus nasschemischem Ätzen und Polieren.

## GEWERBLICHE ANWENDBARKEIT

Ein weiterer Gegenstand der Erfindung betrifft die Verwendung der erfindungsgemäßen Beleuchtungsvorrichtungen zur Ausleuchtung von Räumen. Dabei können die FC LED einzeln eingesetzt oder in Gruppen - beispielsweise auch in Gruppen auf einem Chip - angeordnet sein.

## BEISPIELE

### Beispiele 1 bis 5

Die Zusammensetzung verschiedener Gläser, die im Sinne der vorliegenden Erfindung zur Herstellung der optischen Linsen geeignet sind, sind in **Tabelle 1** wiedergegeben:

**Tabelle 1**

| Glaszusammensetzung | | | | | |
|---|---|---|---|---|---|
| **Komponente** | **1** | **2** | **3** | **4** | **5** |
| Siliziumdioxid | 60 | 55 | 50 | 50 | 50 |
| Titandioxid | 1 | 3 | 5 | 3 | 10 |
| Zirkondioxid | 1 | 2 | 5 | 5 | 2 |
| Calciumoxid | 10 | 10 | 10 | 12 | 10 |
| Magnesiumoxid | 3 | 5 | 13 | 3 | 10 |
| Zinkoxid | 3 | 5 | 5 | 6 | 5 |
| Natriumoxid | 10 | 6 | 6 | 7 | 9 |
| Kaliumoxid | 10 | 12 | 3 | 7 | 2 |
| Lithiumoxid | 2 | 2 | 3 | 7 | 2 |

## Patentansprüche

1. Beleuchtungsvorrichtung umfassend

(a) ein Leuchtelement,
(b) einen Träger sowie
(c) ein Primäroptikelement

wobei

(i) das Leuchtelement (a) auf dem Träger (b) befindlich ist und
(ii) das Primäroptikelement (c) dergestalt auf dem Verbund aus Leuchtelement (a) und Träger (b) angeordnet ist, dass es die aus dem Leuchtelement austretende Strahlung aufnimmt, lenkt und in der gewünschten Lichtverteilung abstrahlt, wobei
(iii) das Primäroptikelement (c) aus hochbrechendem Glas gefertigt und
(iv) durch Ansprengen am Träger befestigt ist, **dadurch gekennzeichnet, dass** das Glas Oxide von vier-, zwei- und einwertigen Metallen aufweist.

**2.** Vorrichtung nach Anspruch 1, **dadurch gekennzeichnet, dass** das Leuchtelement (a) ausgewählt ist aus der Gruppe, die gebildet wird von LED, OLED, LET und OLET.

**3.** Vorrichtung nach den Ansprüchen 1 und/oder 2, **dadurch gekennzeichnet, dass** es sich bei dem Leuchtelement (a) um eine nitridbasierte LED handelt.

**4.** Vorrichtung nach Anspruch 3, **dadurch gekennzeichnet, dass** es sich bei dem Leuchtelement (a) um LEDs handelt, die als Halbleiter GaP, AlP, InP, InGaP, AlGaP und/oder InGaAlP enthalten.

**5.** Vorrichtung nach mindestens einem der Ansprüche 1 bis 4, **dadurch gekennzeichnet, dass** das Leuchtelement (a) und der Träger (b) einen Chip darstellen.

**6.** Vorrichtung nach mindestens einem der Ansprüche 1 bis 5, **dadurch gekennzeichnet, dass** das Primäroptikelement (c) eine Linse darstellt.

**7.** Vorrichtung nach Anspruch 6, **dadurch gekennzeichnet, dass** die Linse einem dem Verbund aus Leuchtelement und Träger zugewandte planare Seite aufweist.

**8.** Vorrichtung nach mindestens einem der Ansprüche 1 bis 7, **dadurch gekennzeichnet, dass** das hochbrechende Glas einen Brechungsindex $n_D$ von mindestens 1,5 besitzt.

**9.** Vorrichtung nach Anspruch 8, **dadurch gekennzeichnet, dass** das hochbrechende Glas einen Brechungsindex $n_D$ von mindestens 1,7 besitzt.

**10.** Vorrichtung nach mindestens einem der Ansprüche 1 bis 9, **dadurch gekennzeichnet, dass** das hochbrechende Glas folgende Zusammensetzung aufweist

(a1) etwa 58 bis etwa 63 Gew.-% vierwertige Metalloxide,
(a2) etwa 14 bis etwa 22 Gew.-% zweiwertige Metalloxide,
(a3) etwa 14 bis etwa 20 Gew.-% einwertige Metalloxide,

mit der Maßgabe, dass sich die Mengenangaben zu 100 Gew.-% addieren.

**11.** Vorrichtung nach mindestens einem der Ansprüche 1 bis 10, **dadurch gekennzeichnet, dass** die zu verbindenden Oberflächen der Einheit aus dem Primäroptikelement (c) einerseits und dem Verbund aus Leuchtelement (a) und Träger (b) andererseits eine

Rauheit ($R_a$) von weniger als 10 nm aufweisen.

**12.** Vorrichtung nach mindestens einem der Ansprüche 1 bis 11, **dadurch gekennzeichnet, dass** die Oberflächen eine Rauheit ($R_a$) von weniger als 5 nm aufweisen.

**13.** Vorrichtung nach mindestens einem der Ansprüche 1 bis 12, **dadurch gekennzeichnet, dass** die zu verbindenden Oberflächen der Einheit aus dem Primäroptikelement (c) einerseits und dem Verbund aus Leuchtelement (a) und Träger (b) andererseits eine Ebenheit (PV) von weniger als 100 nm aufweisen.

**14.** Vorrichtung nach Anspruch 13, **dadurch gekennzeichnet, dass** die Oberflächen eine Ebenheit (PV) von weniger als 50 nm aufweisen.

**15.** Verwendung einer Vorrichtung nach mindestens einem der Ansprüche 1 bis 14 zur Ausleuchtung von Räumen.

**Claims**

**1.** An illuminating device, comprising

(a) a luminous element,
(b) a support, and
(c) a primary optical element,

wherein

(i) said luminous element (a) is present on the support (b), and
(ii) said primary optical element (c) is arranged on the composite of luminous element (a) and support (b) in such a way that it takes up, directs and emits the radiation emerging from the luminous element in the desired light distribution, wherein
(iii) said primary optical element (c) is fabricated from a high refractive index glass and
(iv) attached to the support by direct bonding,

**characterized in that**
said glass contains oxides of tetravalent, divalent and monovalent metals.

**2.** The device according to claim 1, **characterized in that** said luminous element (a) is selected from the group consisting of LEDs, OLEDs, LETs and OLETs.

**3.** The device according to claims 1 and/or 2, **characterized in that** said luminous element (a) is a nitride-based LED.

**4.** The device according to claim 3, **characterized in**

**that** said luminous element (a) is LEDs containing GaP, AIP, InP, InGaP, AlGaP and/or InGaAlP as semiconductors.

5. The device according to at least one of claims 1 to 4, **characterized in that** said luminous element (a) and said support (b) form a chip.

6. The device according to at least one of claims 1 to 5, **characterized in that** said primary optical element (c) is a lens.

7. The device according to claim 6, **characterized in that** said lens has a planar side facing towards the composite of luminous element and support.

8. The device according to at least one of claims 1 to 7, **characterized in that** the high refractive index glass has a refractive index no of at least 1.5.

9. The device according to claim 8, **characterized in that** said high refractive index glass has a refractive index no of at least 1.7.

10. The device according to at least one of claims 1 to 9, **characterized in that** said high refractive index glass has the following composition:

    (a1) about 58 to about 63% by weight of tetravalent metal oxides,
    (a2) about 14 to about 22% by weight of divalent metal oxides,
    (a3) about 14 to about 20% by weight of monovalent metal oxides,

    with the proviso that the amounts sum up to 100% by weight.

11. The device according to at least one of claims 1 to 10, **characterized in that** the surfaces to be bonded of the unit consisting of the primary optical element (c) on the one hand and the composite of luminous element (a) and support (b) on the other have a roughness ($R_a$) of less than 10 nm.

12. The device according to at least one of claims 1 to 11, **characterized in that** the surfaces have a roughness ($R_a$) of less than 5 nm.

13. The device according to at least one of claims 1 to 12, **characterized in that** the surfaces to be bonded of the unit consisting of the primary optical element (c) on the one hand and the composite of luminous element (a) and support (b) on the other have a planarity (PV) of less than 100 nm.

14. The device according to claim 13, **characterized in that** the surfaces have a planarity (PV) of less than 50 nm.

15. Use of a device according to at least one of claims 1 to 14 for illuminating rooms.

**Revendications**

1. Dispositif d'éclairage, comprenant

    (a) un élément lumineux,
    (b) un support, et
    (c) un élément optique primaire,

    dans lequel

    (i) ledit élément lumineux (a) est localisé sur le support (b), et
    (ii) ledit élément optique primaire (c) est arrangé sur le composite de l'élément lumineux (a) et du support (b) de manière qu'il reçoive, dirige et émette dans la distribution de lumière désirée la radiation émanant dudit élément lumineux, dans lequel
    (iii) ledit élément optique primaire (c) est fabriqué à partir de verre à haut indice de réfraction, et
    (iv) est fixé au support par jonction directe,

    **caractérisé en ce que** ledit verre contient des oxydes de métaux tétravalents, divalents et monovalents.

2. Dispositif selon la revendication 1, **caractérisé en ce que** ledit élément lumineux (a) est choisi dans le groupe consistant en LED, OLED, LET et OLET.

3. Dispositif selon les revendications 1 et/ou 2, **caractérisé en ce que** ledit élément lumineux (a) est un LED à base de nitrure.

4. Dispositif selon la revendication 3, **caractérisé en ce que** ledit élément lumineux (a) est des LEDs contenant du GaP, AIP, InP, InGaP, AlGaP et/ou InGaAIP comme semi-conducteur.

5. Dispositif selon l'une au moins des revendications 1 à 4, **caractérisé en ce que** ledit élément lumineux (a) et ledit support (b) représentent une puce.

6. Dispositif selon l'une au moins des revendications 1 à 5, **caractérisé en ce que** ledit élément optique primaire (c) représente une lentille.

7. Dispositif selon la revendication 6, **caractérisé en ce que** ladite lentille présente un côté planaire orienté vers le composite de l'élément lumineux et du support.

8. Dispositif selon l'une au moins des revendications 1 à 7, **caractérisé en ce que** ledit verre à haut indice de réfraction présente un indice de réfraction no d'au moins 1,5.

9. Dispositif selon la revendication 8, **caractérisé en ce que** ledit verre à haut indice de réfraction présente un indice de réfraction no d'au moins 1,7.

10. Dispositif selon l'une au moins des revendications 1 à 9, **caractérisé en ce que** ledit verre à haut indice de réfraction présente la composition suivante :

> (a1) environ 58 à environ 63 % en poids d'oxydes de métaux tétravalents,
> (a2) environ 14 à environ 22 % en poids d'oxydes de métaux divalents,
> (a3) environ 14 à environ 20 % en poids d'oxydes de métaux monovalents,

à condition que les indications quantitatives s'additionnent pour donner 100 % en poids.

11. Dispositif selon l'une au moins des revendications 1 à 10, **caractérisé en ce que** les surfaces à joindre de l'unité consistant en l'élément optique primaire (c) d'une part et l'assemblage dudit élément lumineux (a) et dudit support (b) d'autre part présentent une rugosité ($R_a$) de moins de 10 nm.

12. Dispositif selon l'une au moins des revendications 1 à 11, **caractérisé en ce que** lesdites surfaces présentent une rugosité ($R_a$) de moins de 5 nm.

13. Dispositif selon l'une au moins des revendications 1 à 10, **caractérisé en ce que** les surfaces à joindre de l'unité consistant en l'élément optique primaire (c) d'une part et l'assemblage dudit élément lumineux (a) et dudit support (b) d'autre part présentent une planéité (PV) de moins de 100 nm.

14. Dispositif selon la revendication 13, **caractérisé en ce que** lesdites surfaces présentent une planéité (PV) de moins de 50 nm.

15. Utilisation d'un dispositif selon l'une au moins des revendications 1 à 14 pour l'éclairage de pièces.

**Abbildung 1a**
Aufbau einer konventionellen LED (links) und einer Flip Chip LED (rechts)
Wire bond = Drahtverbindung
Light = Licht
Sapphire = Saphir
Heat = Hitze
Metal reflector = Metallreflektor
Silver reflector = Silberreflektor

**Abbildung 1b**
Lichtaustritt bei einer  konventionellen LED (links) und einer Flip Chip LED (rechts)
Japanische Schriftzeichen = Saphir

**Abbildung 1c**
Lichtaustritt bei einer konventionellen LED mit Lenkvorrichtung für die Strahlung (links) und einer Flip Chip LED (rechts)

**Abbildung 2**
Linsentypen: a) Chip Scale Lens   b) Mushroom Lens   c) Conformal Lens

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 57092881 A
- US 2011062469 A1
- EP 1191608 A2
- US 2012153306 A1
- US 2011062471 A1
- WO 2009132837 A2